Europäisches Patentamt

European Patent Office

Office européen des brevets

(11) Veröffentlichungsnummer: **0 003 509**
**B1**

(12) **EUROPÄISCHE PATENTSCHRIFT**

(45) Veröffentlichungstag der Patentschrift: **20.01.82**

(21) Anmeldenummer: **79100121.7**

(22) Anmeldetag: **16.01.79**

(51) Int. Cl.³: **H 03 G 3/00, H 03 G 1/04, G 01 S 7/62 //A61B10/00**

(54) Verstärkungsregelungsschaltung für eine Mehrzahl hintereinander geschalteter Verstärkungsstufen.

(30) Priorität: **25.01.78 DE 2803204**

(43) Veröffentlichungstag der Anmeldung:
**22.08.79 Patentblatt 79/17**

(45) Bekanntmachung des Hinweises auf die Patenterteilung:
**20.01.82 Patentblatt 82/3**

(84) Benannte Vertragsstaaten:
**FR GB NL**

(56) Entgegenhaltungen:
GB - A - 1 079 893
US - A - 3 367 173
US - A - 3 461 394
US - A - 4 016 862

UNION DES ASSOCIATIONS TECHNIQUES INTERNATIONALES ET LA SOCIETE FRANCAISE DES ELECTRONICIENS ET DE RADIOELECTRICIENS. COLLOQUE INTERNATIONAL SUR LA MICROELECTRONIQUE AVANCEE, PARIS, vol. 2, 6—10 avril 1970; 1970 Chiron, Paris, FR. E. SCHATTER: "TBA 400/410/420-a video IF concept with optimal AGc performance and high sensitivity", Seiten 901—910.

(73) Patentinhaber: **SIEMENS AKTIENGESELLSCHAFT**
**Berlin und München**
**Postfach 22 02 61**
**D-8000 München 22 (DE)**

(72) Erfinder: **Paulke, Bodo**
**Ziegeläckerweg 6**
**D-8524 Neunkirchen (DE)**
Erfinder: **Walz, Alfred**
**Tannenweg 14**
**D-8501 Burgthann (DE)**

(56) Entgegenhaltungen:
WESCON/66 TECHNICAL PAPERS; Jahr- g. 10, Heft 6, 23/26 August 1966 North Hollywood G. C. LUETTGENAU und A.R. BRAND: "Circuit Simplification with IGFETS", Seiten 11/4 von 1 bis 7.

# 0 003 509

Verstärkungsregelungsschaltung für eine Mehrzahl hintereinander geschalteter Verstärkungsstufen

Die Erfindung bezieht sich auf eine Verstärkungsregelungsschaltung für eine Mehrzahl hintereinander geschalteter Verstärkungsstufen zur Verstärkung elektrischer Signale, von denen jede wenigstens ein durch eine eingangsseitige Regelspannung gesteuertes Verstärkerelement umfaßt.

Bei der Kettenschaltung von spannungsgesteuerten Verstärkungsstufen tritt das Problem auf, daß wegen der Herstellungstoleranzen bei den aktiven Elementen, insbesondere solchen, die mit Halbleitern bestückt sind, die einzelnen Stufen bei gleicher Regelspannung unterschiedliche Verstärkungen aufweisen können. Dies birgt die Gefahr, daß bei großen Eingangssignalen während der Verstärkungseinstellung eine der vorderen Verstärkungsstufen der Kette früher als die nachfolgenden übersteuert wird. Die dadurch hervorgerufene Impulsverlängerung führt zur Überblendung nachfolgender Signale.

Dies wird jedoch im allgemeinen nicht so erkannt; vielmehr wird die Impulsverbreiterung irrtümlich als besonders starkes Echo gewertet werden. Die Bedienungsperson wird dementsprechend weiter zu höheren Verstärkungsgraden regeln, obgleich Übersteuerungen bereits stattgefunden haben. Das Nichterkennen dieser Übersteuerung führt jedoch dann zu Verfälschungen des Meßergebnisses. Zu unterschiedlichen Übersteuerungen mit nachfolgender Signalüberblendung kommt es immer besonders leicht bei solchen Verstärkern, bei denen aufgrund des breiten Dynamikbereichs der einkommenden Nutzsignale zum Zwecke des Amplitudenausgleichs ein Regelbereich entsprechend breiter Dynamik erforderlich ist. Signale mit besonders großem Dynamikbereich fallen beispielsweise in der Ultraschall-Impuls-Echo-Meßtechnik an. Hier ergibt sich speziell das Problem, daß nach Einstrahlung eines Sendeimpulses in ein Untersuchungsobjekt, z.B. menschlichen Körper bei der Ultraschall-Diagnostik, Echoimpulse aus den verschiedenen Objektschichttiefen mit sehr unterschiedlichen Intensitäten anfallen. Je größer die Eindringtiefe, desto geringer ist die Intensität des ankommenden Echos. Der Dynamikbereich der Echosignale kann sich dabei zwischen Null bis 100 dB erstrecken. Es ist leicht einzusehen, daß bei Übersteuerung einzelner Verstärkerstufen durch relativ starke Echoimpulse nachfolgende Echoimpulse nicht mehr erfaßt und zur Anzeige gebracht werden können. Bei B-Scan führt dies z.B. zu Fehlern in der longitudinalen Auflösung. Die Bildqualität der Schnittbilder ist stark herabgesetzt. Entsprechendes gilt auch für den A-Scan oder sonstiger Ultraschall-Abtastverfahren. Trotz verminderter Bildqualität wurde die mögliche Übersteuerung einzelner Verstärkerstufen mangels geeigneter Verbesserungsvorschläge bisher in Kauf genommen, zumal an eine numerische Auswertung der empfangenen Echosignale bisher nocht nicht gedacht war.

Unter numerischer Auswertung soll dabei in vorliegendem Fall ganz allgemein ein solches Verarbeitungsverfahren am Ausgangssignal verstanden werden, mit dem aus Beschaffenheit und Form des Ausgangssignals auf die entsprechenden Eigenschaften des originären Signals geschlossen werden kann. Bei der Ultraschall-Diagnostik soll beispielsweise aus dem nach Endverstärkung anfallenden Helligkeitsbild auf die tatsächlich vorhandene Struktur im Untersuchungsobjekt geschlossen werden, was nur dann möglich ist, wenn die Eigenschaften des Übertragungsweges vom Objekt zum Endauswerter genau bekannt sind. Zwar hätte zumindest hinsichtlich der Übersteuerungsnachteile eine gewisse Abhilfe geschaffen werden können, sofern in der Verstärkungsschaltung entlang der Kette mit steigender Verstärkungsstufennummer aktive Verstärkerelemente mit entsprechend stufenweise höhergestufter Verstärkung eingesetzt worden wären. Dieses Verfahren hätte jedoch eine fertigungstechnisch umständliche Selektion der aktiven Verstärkerelemente erfordert, was das Gesamtgerät unnötigerweise verteuert hätte. Darüber hinaus wäre jedoch bei einer in dieser Weise konzipierten Verstärkungsschaltung die Verstärkung der einzelnen Stufen zwangsläufig unterschiedlich. Eine solche Verstärkungsschaltung wäre damit für eine numerische Auswertung in der oben beschriebenen Art ungeeignet.

Aufgabe vorliegender Erfindung ist es, eine Kettenschaltung von Verstärkungsstufen durch gegenseitige Angleichung der Steuerkennlinien der einzelnen Stufen zum Erhalt gleicher Stufenverstärkung unabhängig vom Signalpegel dahingehend auszubilden, daß ein Übersteuerungsverhalten mit Störeffekten der vorstehend beschriebenen Art nicht mehr auftreten kann.

Die Aufgabe wird erfindungsgemäß dadurch gelöst, daß für wenigstens jedes derjenigen Verstärkerelemente jeder Verstärkungsstufe, die untereinander unterschiedliche Steuerkennlinien aufweisen, ein eigenes Regelspannungsformglied vorhanden ist, das aus einer eingangsseitig angelegten Primärregelspannung $U_{ST1}$ eine, Sekundärregelspannung $U_{ST2}$ formt, die speziell nach der Spannungsabhängigkeit

$$U_{ST2} = m \, U_{ST1} + n$$

verläuft, wobei m und n numerische Formgrößen sind, die am Regelspannungsformglied für jedes Verstärkerelement individuell unterschiedlich einstellbar sind in dem Sinne, daß Unterschiedlichkeiten in den Steuerkennlinienverläufen durch Anpassung an eine jedem Verstärkerelement gemeinsame gleiche Kennlinie ausgeglichen werden.

Mit der Erfindung ist erreicht, daß die Verstärkung in sämtlichen Einzelstufen von einer angelegten Regelspannung über einen beliebig einstellbaren Dynamikbereich dieselbe Abhängigkeit aufweist. Es kann damit nicht mehr zu unkontrollierten Übersteuerungseffekten an einzelnen Verstärkungsstufen innerhalb der Gesamtkette kommen, da jetzt auf jeden Fall immer zuerst die letzte Stufe einer Kette das Signal begrenzt, so daß eine Übersteuerung unmittelbar und eindeutig von der Bedienungsperson festgestellt werden kann. Die damit verbundenen Nachteile können also nicht mehr auftreten. Darüber hinaus ergibt sich jedoch auch aufgrund gemeinsam vorgebbarer Steuerkennlinie für sämtliche Einzelstufen der Vorteil der eindeutigen Reproduzierbarkeit der Eingangsgröße bei bekannter Ausgangsgröße aus diesem Kennlinienverlauf. Eine Verstärkungsregelungsschaltung gemäß der Erfindung erlaubt also die numerische Auswertung im obigen Sinne mit einfachsten technischen Mitteln.

Gemäß der Erfindung bewirkt eine Variation des Faktors m speziell eine Änderung der Steigung des Kennlinienverlaufes. Die Kennlinie wird hierdurch also gedreht bzw. geschwenkt. Eine Variation der Formgröße n bewirkt hingegen eine Parallelverschiebung der gesamten Regelkennlinie. Somit lassen sich also zumindest im Linearbereich der Kennlinien die Toleranzen von aktiven Verstärkungselementen durch Abgleich zumindest in zwei Punkten kompensieren.

Das Schwenken sowie Parallelverschieben einer Kennlinie zum Zwecke einer deckungsgleichen Überführung dieser Kennlinie in eine andere Kennlinie ist in anderem Zusammenhang an sich bereits durch die DT—PS 21 14 064 vorbekannt. Gegenstand dieser Patentschrift ist ein Fotometer zum Bestimmen des Sauerstoffgehaltes von Blut, wo bei Verwendung von sauerstoffreduziertem Blut($0\% \ O_2$) zwie sich bei der Einstrahlung von zwei unterschiedlichen Lichtwellenlängen ergebende Ausgangskennlinien der empfangenen Spektralintensität in Abhängigkeit vom Hämoglobingehalt des Blutes deckungsgleich ineinander übergeführt werden. Diese deckungsgleiche Überführung gilt jedoch nur für den Spezialfall von sauerstoffreduziertem Blut. Sie gilt jedoch nicht für all jene Intensitätssignale, die aus Blut mit von Null unterschiedlichem Sauerstoffgehalt anfallen. Gerade diese Signale weisen also auch weiterhin unterschiedliche Kennlinienverläufe auf; sie müssen es auch, da schließlich aus ihrer Abweichung von der $0\% \ O_2$-Kennlinie, die speziell für die Wellenlänge 805 nm immer konstant bleibt, der Hämoglobingehalt des Blutes erfaßt werden soll. Beim Fotometer nach der DT—PS 21 14 064 wird also durch Überführung einer zuerst vom Hämoglobingehalt des Blutes abhängigen Null-Kennlinie für den Sauerstoffgehalt in eine solche Null-Kennlinie, die vom Hämoglobingehalt unabhängig ist, ein Nullnormal für den Sauerstoffkennlinienverlauf geschaffen. Der Überführungsabgleich (Nullabgleich) erfolgt durch Beeinflussung des Verstärkerausgangssignals. Jeder weitere Kennlinienverlauf ist dazu unterschiedlich in Abhängigkeit vom Sauerstoffgehalt des Blutes. Demgegenüber ist es jedoch signifikantes Merkmal vorliegender Erfindung, daß speziell Steuerkennlinien einer Vielzahl von nacheinandergeschalteten Stufen eines Verstärkers sämtliche an eine gemeinsame Kennlinie angepaßt werden. Diese Kennlinie ist nicht die Kennlinie eines Ausgangssignals, sondern eine Steuerkennlinie. Der Eingriff erfolgt also nicht im Ausgangssignal, sondern im Steuerbereich des Verstärkers selbst. Es ergeben sich keine weiteren Kennlinienverläufe, deren Abweichungen vom genormten Kennlinienverlauf sämtlicher Stufen ein Maß für eine bestimmte Meßgröße abgeben. Abgesehen vom unterschiedlichen Anwendungsbereich unterscheiden sich also die beiden Gegenstände auch grundsätzlich in Aufgabenstellung and Lösung.

Weitere Vorteile und Einzelheiten der Erfindung ergeben sich aus der nachfolgenden Beschreibung von Ausführungsbeispielen anhand der Zeichnung in Verbindung mit den Unteransprüchen.

Es zeigen:

Fig. 1 die wesentlichen Bauelemente einer einzelnen Verstärkungsstufe aus einer Gesamtkette mit einem Regelspannungsformglied in einer ersten Ausführungsform,

Fig. 2 ein Regelspannungsformglied mit gegenüber der Fig. 1 modifizierter Ausbildungsform,

Fig. 3 einen Verstärker mit drei Verstärkungsstufen nebst zugeordneten Regelspannungsformgliedern im Prinzipaufbau.

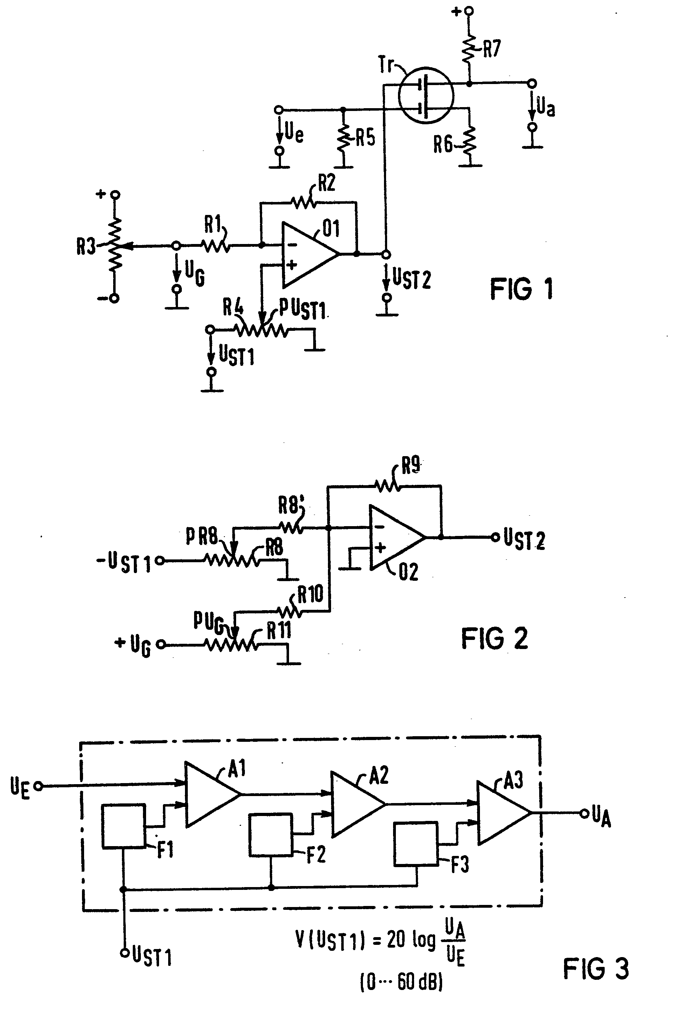

In der Fig. 1 umfaßt ein Regelspannungsformglied einen Operationsverstärker 01 mit einem ersten Eingangswiderstand R1 und einem Gegenkoppelwiderstand R2 am invertierenden Eingang. Am Widerstand R1 liegt eingangsseitig eine Gleichspannung $U_G$, die mittels Eingangspotentiometer R3, das ungeerdet an einer Gleichspannung liegt, in bestimmten Grenzen variierbar ist. Der Widerstand R3 ist, um Einflüsse auf die Verstärkung zu vermeiden, niederohmig. Er beträgt vorzugsweise 1/10 des Widerstandswertes R1. Am nicht invertierenden Eingang des Operationsverstärkers 01 liegt der Teilerabgriff eines Widerstandspotentiometers R4. R4 soll wiederum vorzugsweise niederohmig sein, d.h. z.B. ebenfalls im Bereich 1/10 von R1 liegen. Am Widerstandspotentiometer R4 liegt die Primärregelspannung $U_{ST1}$. Die jeweils abgegriffene Teilspannung besitzt den Wert $p \ U_{ST1}$, wobei p in den Grenzen $0 \leq p \leq 1$ variierbar ist. Die sich am Ausgang des Operationsverstärkers 01 einstellende Spannung $U_{ST2}$ ist die Sekundärregelspannung für den Spannungssteuereingang eines aktiven Verstärkerelements Tr einer beliebigen Verstärkungsstufe in einem Regelverstärker (bei Ultraschall-Geräten Tiefenausgleichverstärker). Im vorliegenden Fall ist das aktive Verstärkerelement Tr speziell ein Dual-Gate-Mosfet. Es kann sich hierbei jedoch auch beispielsweise um eine bipolaren Transistor oder um eine steuerbare Verstärkerröhre od.dgl. handeln. Der DGM-Transistor Tr ist mit Beschaltungswiderständen R5, R6 und R7 bestückt. Das zu verstärkende Eingangssignal ist mit $U_e$ bezeichnet. Das verstärkte Ausgangssignal ist mit $U_a$ bezeichnet.

Mit dem Formglied der Fig. 1 ergibt sich die Sekundärregelspannung $U_{ST2}$ in Abhängigkeit von der Primärregelspannung $U_{ST1}$ und der Gleichspannung $U_G$ sowie der Widerstandsbeschaltung wie folgt:

$$U_{ST2} = p\, U_{ST1}\, (1 + \frac{R2}{R1}) - \frac{R2}{R1}\, U_G.$$

Mit der Beziehung

$$U_{ST2} = m\, U_{ST1} + n$$

ergibt sich also für m und n die Beziehung

$$m = p\, (1 + \frac{R2}{R1})$$

$$n = -\frac{R2}{R1}\, U_G.$$

Man sieht sofort, daß durch entsprechende Wahl der Widerstände R2 und R1 aus deren Verhältnis ein Maximalwert einer Änderung der Steigung der Regelkennlinie festgelegt ist. Durch Änderung des Faktors p in den Grenzen $0 \le p \le 1$ am Widerstandspotentiometer R4 kann dann der Wert m zwischen diesem Maximalwert und einem Minimalwert (Null) variiert werden. Eine Parallelverschiebung der Regelkennlinie erfolgt durch Änderung der Formgröße n be Einstellung unterschiedlicher Gleichspannungen $U_G$ mittels des Potentiometers R3.

Im Ausführungsbeispiel der Fig. 1 ergibt sich eine besondere Vereinfachung, wenn R1 = R2 gesetzt wird. Hieraus folgt die Beziehung

$$U_{ST2} = 2p\, U_{ST1} - U_G.$$

Der Variationsbereich der Kennlinien liegt hier in den Grenzen 0 bis 2. Die Formgröße n ergibt sich unmittelbar aus der Größe der gewählten Gleichspannung $U_G$.

Eine Modifikation des Formgliedes ergibt sich gemäß Fig. 2. Mit dieser Schaltung ist die Beziehung zwischen Primärregelspannung $U_{ST1}$ und Sekundärregelspannung $U_{ST2}$ wie folgt:

$$U_{ST2} = p\, \frac{R9}{R8'}\, U_{ST1} - q\, \frac{R9}{R10}\, U_G;\ \frac{R9}{R8'} > 1.$$

Die Formgrößen m und n sind hier gegeben durch

$$m = p\, \frac{R9}{R8'}$$

$$n = -q\, \frac{R9}{R10}\, U_G.$$

In beiden Ausführungsbeispielen empfiehlt es sich, zur Kompensation von Temperatureffekten als Gegenkoppelwiderstand R2 bzw. R9 einen weiteren Feldeffekttransistor mit Serienwiderstand in Temperaturkompensationsschaltung einzusetzen.

Mit den genannten Schaltungen lassen sich also für jeden Transistor Tr in einer Verstärkungsstufe einer Verstärkerkettenschaltung Sekundärregelspannungen $U_{ST2}$ anlegen, die mit der Primärregelspannung $U_{ST1}$ durch die Beziehung $U_{ST2} = m \cdot U_{ST1} + n$ verknüpft sind. Die Formgrößen m und n sind dabei am Regelspannungsformglied für jedes Verstärkerelement individuell unterschiedlich einstellbar in dem Sinne, daß Unterschiedlichkeiten in den Steuerkennlinienverläufen $V(U_{ST})$ durch Anpassung an eine gemeinsam vorgebbare Kennlinie ausgeglichen werden.

Ein Ausführungsbeispiel für einen Verstärker mit beispielsweise drei Verstärkungsstufen A1, A2, A3 in Kettenschaltung, die aufgrund entsprechender Vorwahl von Regelspannungsformgrößen an Regelspannungsformgliedern F1, F2 und F3 sämtliche denselben Steuerkennlinienverlauf aufweisen, ist im Prinzipschaltbild der Fig. 3 dargestellt. Mit der für sämtliche Stufen gemeinsamen Primärregelspannnung $U_{ST1}$, mit der die Verstärkung z.B. im Bereich Null bis 60 dB varriierbar ist, ergibt sich die Gesamtverstärkung der Verstärkerkette zu

$$V(U_{ST1}) = 20 \log \frac{U_A}{U_E}.$$

Bei somit über den gesamten Dynamikbereich bekanntem Verstärkungsverlauf läßt sich jedoch dann durch entsprechende Rückrechnung aus dem Ausgangssignal $U_A$ das Ursprungssignal (Eingangssignal $U_E$) im originären Verlauf ermitteln. Der Verstärker gemäß den Fig. 1 bis 3 ermöglicht also eine numerische Auswertung in der eingangs beschriebenen Weise.

**Patentansprüche**

1. Verstärkungsregelungsschaltung für eine Mehrzahl hintereinander geschalteter Verstärkungsstufen zur Verstärkung elektrischer Signale, von denen jede wenigstens ein durch eine eingangsseitige Regelspannung gesteuertes Verstärkerelement umfaßt, dadurch gekennzeichnet, daß für wenigstens jedes derjenigen Verstärkerelemente (Tr) jeder Verstärkungsstufe (A1 bis A3), die untereinander unterschiedliche Steuerkennlinien $V(U_{ST})$ aufweisen, ein eigenes Regelspannungsformglied (F1 bis F3) vorhanden ist, das aus einer eingangsseitig angelegten Primärregelspannung $U_{ST1}$ eine Sekundärregelspannung $U_{ST2}$ formt, die speziell nach der Spannungsabhängigkeit

$$U_{ST2} = m \, U_{ST1} + n$$

verläuft, wobei m und n numerische Formgrößen sind, die am Regelspannungsformglied (F1 bis F3) für jedes Verstärkerelement (Tr) individuell unterschiedlich einstellbar sind in dem Sinne, daß Unterschiedlichkeiten in den Steuerkennlinienverläufen $V(U_{ST})$ durch Anpassung an eine jedem Verstärkerelement gemeinsame gleiche Kennlinie ausgeglichen werden.

2. Verstärkungsregelungsschaltung nach Anspruch 1, dadurch gekennzeichnet, daß zur Vorgabe des Faktors m das Regelspannungsformglied (F1 bis F3) Spannungsteiler und/oder Verstärkungsglieder für die Primärregelspannung $U_{ST1}$ umfaßt.

3. Verstärkungsregelungsschaltung nach Anspruch 2, dadurch gekennzeichnet, daß zur Vorgabe der Formgröße n eine Gleichspannung ($U_G$) dem Produktsignal $m \cdot U_{ST1}$ additiv überlagerbar ist.

4. Verstärkungsregelungsschaltung nach Anspruch 2 oder 3, dadurch gekennzeichnet, daß zur Einstellung des Faktors m ein Operationsverstärker (01 oder 02) dient, der mit dem Verhältnis aus einem ersten Eingangswiderstand (R1 bzw. R8') und einem Gegenkoppelwiderstand (R2 bzw. R9) einen Maximalwert des Faktors m festlegt, und daß durch einen dem Operationsverstärker (01 bzw. 02) weiter vorgeschalteten oder am zweiten nichtinvertierenden Verstärkereingang angeschalteten einstellbaren Spannungsteiler (R4 bzw. R8) der Wert m zwischen diesem Maximalwert und einem Minimalwert variierbar ist.

5. Verstärkungsregelungsschaltung nach Anspruch 3 und 4, dadurch gekennzeichnet, daß zur Einstellung der Konstanten n der Operationsverstärker (01 bzw. 02) eingangsseitig zusätzlich mit einer Gleichspannung ($U_G$) beaufschlagbar ist.

6. Verstärkungsregelungsschaltung nach Anspruch 4 und 5, dadurch gekennzeichnet, daß der Spannungsteiler (R4 bzw. R8) die Primärregelspannung ($U_{ST1}$) mit einem Faktor p ($o \leq p \leq 1$) wichtet, der den Wert des Faktors m zwischen Maximalwert und Minimalwert in der Größe festlegt.

7. Verstärkungsregelungsschaltung nach einem der Ansprüche 1 bis 6, dadurch gekennzeichnet, daß die Primärregelspannung ($U_{ST1}$) für sämtliche Verstärkerstufen (A1 bis A3) dieselbe ist.

**Revendications**

1. Montage pour le réglage du gain pour plusieurs étages d'amplification montés l'un à la suite de l'autre en vue de l'amplification de signaux électriques, et dont chacun comporte au moins un élément amplificateur commandé par une tension de réglage d'entrée, caractérisé par le fait qu'il est prévu, au moins pour chacun de ceux des éléments amplificateurs (Tr) de chaque étage d'amplification (A1 à A3), qui possèdent des courbes caractéristiques de commande $V(U_{ST})$ qui diffèrent entre elles, un élément de formation de la tension de réglage (F1 à F3) qui lui est propre et qui forme, à partir d'une tension primaire de réglage ($U_{ST1}$) appliquée à l'entrée, une tension secondaire de réglage ($U_{ST2}$) dont l'allure correspond particulièrement à la relation

$$U_{ST2} = m \, U_{ST1} + n$$

dans laquelle m et n sont des valeurs numériques de forme qui sont susceptibles d'être réglées différemment et individuellement pour chaque élément amplificateur au niveau de l'élément de formation de la tension de réglage de manière que les différences qui apparaissent dans les courbes caractéristiques de commande (V5U$_{ST}$) soient compensées par adaptation à une même courbe caractéristique commune à chaque élément amplificateur.

2. Montage pour la régulation du gain selon la revendication 1, caractérisé par le fait que pour donner à l'avance le facteur m, l'élément de formation de la tension de régulation (F1 à F3) comporte des diviseurs de tension et/ou des éléments amplificateurs pour la tension de régulation primaire (U$_{ST1}$).

3. Montage pour la régulation du gain selon la revendication 2, caractérisé par le fait que pour donner à l'avance la grandeur de forme n, une tension continue (U$_G$) est susceptible d'être superposée additivement au signal-produit m · U$_{ST1}$.

4. Montage pour la régulation du gain selon la revendication 2 ou 3, caractérisé par le fait que pour régler le facteur m, on met en oeuvre un amplificateur opérationnel (01 ou 02) qui détermine, avec le rapport entre une première résistance d'entrée (R1 ou R8') et une résistance de contre-réaction (R2 ou R9) une valeur maximale du facteur m et par le fait qu'à l'aide d'un diviseur de tension réglable (R4 ou R8) monté en amont de l'amplificateur opérationnel (01 ou 02) ou relié à la seconde entrée non inverseuse de l'amplificateur, la valeur m est susceptible d'être modifiée entre cette valeur maximale et une valeur minimale.

5. Montage pour la régulation du gain selon les revendications 3 et 4, caractérisé par le fait que pour le réglage de la constante n, l'amplificateur opérationnel (01 ou 02) est de plus susceptible d'être chargé, au niveau de son entrée, avec une tension continue (U$_G$).

6. Montage pour la régulation du gain selon la revendication 4 ou 5, caractérisé par le fait que le diviseur de tension (R4 ou R8) procède à la pondération de la tension de régulation primaire (U$_{ST1}$) avec le facteur p (0 ≤ p ≤ 1) qui détermine la grandeur de la valeur du facteur m entre la valeur maximale et la valeur minimale.

7. Montage pour la régulation du gain selon l'une des revendications 1 à 6, caractérisé par le fait que la tension de régulation primaire (U$_{ST1}$) est la même pour tous les étages d'amplification (A1 à A3).

## Claims

1. An amplification control circuit for a plurality of series-connected amplification stages for the amplification of electric signals, of which each stage comprises at least one amplification element controlled by a control voltage at the input end, characterised in that there is provided for at least each of the amplification elements (Tr) of each amplification stage (A1 to A3) which have different control characteristics V (U$_{ST}$), a separate control voltage generator (F1 to F3), which generates a secondary control voltage U$_{ST2}$ from a primary control voltage U$_{ST1}$ which is applied at the input end, which secondary control voltage takes a course specifically in accordance with the voltage dependence

$$U_{ST2} = m\ U_{ST1} + n$$

where $m$ and $n$ are numerical generating magnitudes which can be individually set for each amplifier element (Tr) at the control voltage generating unit (F1 to F3) to enable compensation of differences in the course of the control characteristics V(U$_{ST}$) by matching to a similar characteristic which is common to each amplifier element.

2. An amplification control circuit as claimed in claim 1, characterised in that to determine the factor $m$ the control voltage generating unit (F1 to F3) comprises voltage dividers and/or amplification elements for the primary control voltage U$_{ST1}$.

3. An amplification control circuit as claimed in claim 2, characterised in that to determine the generating magnitude $n$ a direct voltage (U$_G$) additive is superimposed on the production signal m·U$_{ST1}$.

4. An amplification circuit as claimed in claim 2 or 3, characterised in that an operational amplifier (01 or 02) which determines a maximal value of the factor $m$ in accordance with the ratio from a first input resistance (R1 or R8') and a feedback resistance (R2 or R9) serves to set the factor $m$, and that the value $m$ can be varied between this maximal value and a minimal value by an adjustable voltage divider (R4 or R8) which is further connected preceding an operation amplifier (01 ≤ or ≤ 02) or connected to the second non-inverting amplifier input.

5. An amplification control circuit as claimed in claim 3 and 4, characterised in that to set the constant $n$ the operational amplifier (01 or 02) is additionally connected to a direct voltage (U$_G$) at the input end.

6. An amplification control circuit as claimed in claim 4 and 5, characterised in that the voltage divider (R4 or R8) adjusts the primary control voltage (U$_{ST1}$) by a factor $p$ (o ≤ p ≤ 1) which determines the value of the factor $m$ between the maximal and minimal values.

7. An amplification control circuit as claimed in one of the claims 1 to 6, characterised in that the primary control voltage (U$_{ST1}$) is the same for all amplification stages (A1 to A3).

0 003 509

FIG 1

FIG 2

$$V(U_{ST1}) = 20 \log \frac{U_A}{U_E}$$

$$(0 \cdots 60\,dB)$$

FIG 3